# FASCICULE DE BREVET EUROPEEN

(11) **EP 2 933 224 B1**
(45) Date de publication et mention de la délivrance du brevet: **16.11.2016**
(21) Numéro de dépôt: 15163617.2
(22) Date de dépôt: 15.04.2015
(51) Int. Cl.: B81B 7/00

(54) **Circuit de mesure**
Messkreis
Measurement circuit

(30) Priorité: 15.04.2014 FR 1453346
(43) Date de publication de la demande: 21.10.2015
(73) Titulaire: COMMISSARIAT A L'ENERGIE ATOMIQUE ET AUX ENERGIES ALTERNATIVES, 75015 Paris (FR)
(72) Inventeur: Joet, Loic, 38000 GRENOBLE (FR); Badets, Franck, 38500 VOIRON (FR); Jourdan, Guillaume, 38000 GRENOBLE (FR); Rey, Patrice, 38430 ST JEAN DE MOIRANS (FR)
(74) Mandataire: Decobert, Jean-Pascal

(56) Documents cités:
- SAYED JAVAD AZHARI ET AL: "AZKA Cell, the Current-Mode Alternative of Wheatstone Bridge", IEEE TRANSACTIONS ON CIRCUITS AND SYSTEMS PART I: REGULAR PAPERS, IEEE SERVICE CENTER, NEW YORK, NY, US, vol. 47, no. 9, 1 septembre 2000 (2000-09-01), XP011012187, ISSN: 1057-7122
- FARSHIDI E: "A Low-Voltage Current-Mode Wheatstone Bridge using CMOS Transistors", 28 février 2011 (2011-02-28), International Journal of Electrical & Electronics Engineering; Issue 1, XP002734491, vol. 5, pages 38-42, * le document en entier *
- TANAPHATSIRI C ET AL: "A current-mode wheatstone bridge employing only single DO-CDTA", CIRCUITS AND SYSTEMS, 2008. APCCAS 2008. IEEE ASIA PACIFIC CONFERENCE ON, IEEE, PISCATAWAY, NJ, USA, 30 novembre 2008 (2008-11-30), pages 1494-1497, XP031405288, ISBN: 978-1-4244-2341-5

## Description

### DOMAINE DE L'INVENTION

La présente invention est relative à l'industrie de la microélectronique, qui couvre aussi bien les techniques de la microélectronique que de la nanoétectronique. En particulier, l'invention concerne un circuit de mesure pour capteur, destiné notamment à un microsystème électromécanique (en anglais « MEMS » pour « microelectromechanical system ») et/ou un nanosystème électromécanique (en anglais « NEMS » pour « nanoelectromechanical system »).

### ARRIERE-PLAN TECHNOLOGIQUE

Le marché grand public des capteurs s'oriente vers des tailles de composants toujours plus petites pour atteindre un coût compétitif. Toutefois, les circuits de mesure pour capteurs s'avèrent particulièrement complexes car nécessitent une électronique de lecture capable de détecter les variations d'impédances de dipôles.

Les impédances peuvent être de nature résistive comme tel est le cas pour les jauges de contrainte piézorésistives, les thermistances, de nature capacitive (variation de capacité par variation de surface ou d'entre-fer), ou encore de nature inductive. Le circuit de mesure doit être configuré pour coopérer avec des capteurs passifs pour des microsystèmes électromécaniques (en anglais « MEMS » pour « microelectromechanical system ») ou nanosystèmes électromécaniques (en anglais « NEMS » pour « nanoelectromechanical system ») tels que des capteurs de pression, des capteurs de température, des accéléromètres de une à trois dimensions, des magnétomètres de une à trois dimensions, des gyromètres de une à trois dimensions, des capteurs de déformation ou d'effort à base de jauges de déformation piézorésistives.

Les capteurs passifs s'appuient sur différents phénomènes physiques (piézorésistivité, photorésistivité, magnétorésistivité, variation de capacité induite par variation de surface ou variation d'entre-fer, etc.) pour modifier leur impédance en fonction de la valeur de mesurande devant être évaluée (contrainte, déformation, déplacement, flux lumineux, champ magnétique, etc.). Ces capteurs requièrent généralement une source de tension ou de courant pour polariser les impédances des dipôles et assurer ainsi la mesure de leur variation. Il est nécessaire pour ce type de montage de recourir à des conditionneurs qui codent les informations, et plus particulièrement aux montages potentiométriques.

Dans l'état de la technique antérieure, la solution la plus couramment utilisée est le pont de Wheastone. Dans le domaine des capteurs multi-axes, plusieurs ponts doivent être alimentés et lus. Pour limiter le nombre de plots nécessaires à la polarisation et à la lecture, le plus souvent, seul un demi-pont de Wheastone est réalisé au moyen de deux impédances variables. Le pont est refermé sur une puce électronique suite à l'ajout de deux résistances de référence.

Dans le cadre d'une lecture multiaxe, on peut partager le plot d'alimentation. En effet, il est possible dans ce cas d'alimenter et lire les ponts indépendamment les uns des autres. Dans certains cas, une seule électronique est mise en place possédant une double fonction : de polarisation et de lecture des ponts de manière successive.

Toutefois, une des difficultés, pour tirer pleinement partie des avantages du pont de Wheastone, est liée aux résistances parasites de connexion entre les éléments du pont et les circuits extérieurs d'alimentation. L'impact des résistances parasites peut être minimisé si leur valeur est négligeable devant celle des résistances du pont pour une précision de mesure donnée. Néanmoins, certaines techniques de fabrication, telles que le passage par un scellement or-silicium (entre la puce et son capot) peuvent amener des résistances parasites du même ordre de grandeur que les résistances à mesurer, non connues, non maitrisées, pouvant varier au cours du temps et en température.

Dans ce cas, il est nécessaire de s'affranchir de ces résistances parasites pour ne pas perturber la mesure, notamment par des techniques de connexion dites « quatre pointes ». Le principe de cette technique est de doubler les plots servant à l'alimentation. Le premier plot sert alors à apporter le courant. Ce courant va entrainer une chute de potentiel dans la résistance parasite, rendant le potentiel extérieur différent du potentiel intérieur. Cet effet n'aura toutefois pas d'incidence car la lecture pourra se faire sur le second plot. La lecture ne mettant en jeu que des courants négligeables, les potentiels intérieurs et extérieurs seront les mêmes.

Dans un mode « quatre pointes » à un pont, les plots de mesure ne sont en général pas doublés car l'électronique de mesure présente une impédance très forte et le courant les traversant est très faible. Cependant, la tension appliquée par la source ne pourra se propager intégralement au pont à cause de la chute de tension dans les résistances parasites. Le nombre de plots est ainsi doublé afin de pouvoir mesurer la tension effectivement apportée au pont. Une électronique de lecture sera nécessaire afin de mesurer la tension de polarisation.

Selon un mode de réalisation, le pont de Wheastone entier a été placé au niveau de la puce MEMS et le nombre de plots a été doublé, aboutissant à un nombre de plots rédhibitoire, notamment dans le cadre d'un capteur multiaxe.

Par ailleurs, le document intitulé : « A Low-Voltage Current Mode Wheastone Bridge using CMOS transistors », de Farshidi et al., International Journal of Electrical & Electronics Engineering, Issue 1 vol.5, pages 38-42, concerne un circuit de mesure comprenant un pont de Wheastone. Ce document prévoit une sortie du circuit en courant. Or, les convertisseurs analogiques, par exemple, travaillent exclusivement en tension. Ainsi, dans ce type de circuit, il est nécessaire d'ajouter un étage de conversion courant-tension pour transformer la sortie en courant en une sortie en tension. Un inconvénient majeur est de ce fait la complexité du montage et le coût important que requiert la réalisation d'un tel circuit.

La présente invention permet de résoudre tout ou, du moins, une partie des inconvénients générés par la méthode du pont de Wheastone. L'invention propose en outre un circuit de mesure simple, peu coûteux, servant d'alternative au pont de Wheastone, tout en s'affranchissant des inconvénients jusqu'alors rencontrés.

### RESUME DE L'INVENTION

L'invention concerne un circuit de mesure pour un capteur comprenant au moins une branche de détection comprenant au moins une première série d'au moins un dipôle et une deuxième série d'au moins un dipôle, les séries étant montées en parallèle et reliées en entrée à un plot d'entrée commun ; chaque série de dipôles étant reliée à un plot de sortie distinct.
Avantageusement, le circuit électronique comprend un circuit de polarisation configuré pour appliquer un courant de polarisation dans ladite branche de détection à partir du plot d'entrée, et un circuit de lecture, comprenant au moins une source de courant pilotée en tension, configuré pour imposer à chaque plot de sortie un même potentiel dit potentiel de référence (V_{REF}) ; ledit circuit électronique comportant un circuit de détermination de variations d'impédances de chaque série de dipôles de la branche de détection à partir du courant appliqué à chaque plot de sortie par le circuit de lecture pour maintenir l'égalité des potentiels ; le circuit de détermination est configuré pour fournir en sortie un signal en tension proportionnel à la différence entre le courant au niveau du plot de sortie de la première série de dipôles et le courant au niveau du plot de sortie de la deuxième série de dipôles.

De manière particulièrement avantageuse, la sortie du circuit selon la présente invention est en tension.

Selon l'invention, le circuit de lecture est un circuit actif susceptible d'imposer un potentiel identique, dit potentiel de référence, à chaque plot de sortie qui peut-être fixe ou variable grâce à l'application de courants distincts (mais pas forcément différents) au niveau de chaque plot de sortie.

L'invention concerne également un capteur comprenant au moins un circuit de mesure.

L'invention concerne d'autre part un procédé de mesure comprenant l'utilisation d'un circuit de mesure comprenant au moins une branche de détection comprenant une première série d'au moins un dipôle et une deuxième série d'au moins un dipôle, les séries étant montées en parallèle et reliées en entrée à un plot d'entrée commun ; chaque série de dipôles étant reliée à un plot de sortie distinct et comprenant les étapes suivantes :
- application d'un courant de polarisation dans ladite branche de détection à partir du plot d'entrée,
- imposition à chaque plot de sortie d'un même potentiel dit de référence (V_{REF}),
- détermination de variations d'impédances de chaque série de dipôles de la branche de détection, au moyen d'un circuit de détermination, à partir du courant appliqué à chaque plot de sortie pour maintenir l'égalité des potentiels; le circuit de détermination étant configuré pour fournir en sortie un signal en tension proportionnel à la différence entre le courant au niveau du plot de sortie de la première série de dipôles et le courant au niveau du plot de sortie de la deuxième série de dipôles.

Avantageusement, le circuit de mesure de la présente invention propose une alternative au pont de Wheastone. Dans la présente invention, l'électronique de lecture et les impédances des séries de dipôles interagissent afin d'assurer un potentiel de référence (V_{REF}) au niveau des plots de sortie desdites séries de dipôles. La présente invention permet également d'éviter le recours à des résistances de référence pour compléter le pont.

L'invention permet aussi avantageusement de minimiser le nombre de plots de sortie dans le cas d'une lecture de plusieurs axes de détection. D'autre part, il n'est pas utile de mesurer une tension de polarisation effective. Les impédances des première et deuxième séries de dipôles peuvent être alimentées indépendamment les unes par rapport aux autres pour limiter la consommation de polarisation. Les impédances peuvent être lues en même temps par la même électronique afin d'augmenter les performances.

### BREVE INTRODUCTION DES FIGURES

D'autres caractéristiques, buts et avantages de la présente invention ressortiront mieux de la description détaillée de modes de réalisation de cette dernière, qui sont illustrés par les dessins d'accompagnement suivants dans lesquels :
La FIGURE 1 illustre une représentation schématique du circuit de mesure selon l'invention, le circuit comprenant au moins une branche de détection, un circuit de polarisation et un circuit de lecture.
La FIGURE 2A illustre une représentation schématique du circuit de mesure comprenant une seule branche de détection et un circuit de lecture comprenant des moyens de détermination des variations de dipôles ; lesdits dipôles étant positionnés dans ladite branche de détection.
La FIGURE 2B illustre une représentation schématique d'un circuit de mesure comprenant une sortie en tension différentielle.
La FIGURE 3 illustre une représentation schématique du circuit de mesure selon l'invention comprenant une pluralité de branches de détection, chacune des branches de détection comprenant un plot de polarisation distinct. Un interrupteur relié à une source de polarisation permet de commuter sur chacun des plots de polarisation de différentes branches.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DETAILLEE

Avant d'entamer une revue détaillée de modes de réalisation de l'invention, sont énoncées ci-après des caractéristiques optionnelles qui peuvent éventuellement être utilisées en association ou alternativement :
- Avantageusement, le circuit de détermination est configuré pour fournir en sortie un signal en tension proportionnel à la différence entre le courant au niveau du plot de sortie de la première série de dipôles et le courant au niveau du plot de sortie de la deuxième série de dipôles.
- Préférentiellement, le circuit de détermination, formant des moyens de détermination, est configuré pour assurer l'égalité entre un premier potentiel relevé au niveau de l'un parmi les plots de sortie et un deuxième potentiel relevé au niveau de l'autre parmi les plots de sortie.

- Le circuit de détermination comprend de préférence un amplificateur configuré de sorte à comparer, à son entrée, les premier et deuxième potentiels au niveau de chacun des plots de sortie desdites première et deuxième séries de dipôles.
- L'au moins un amplificateur est configuré de sorte à générer à sa sortie un signal en tension « out ».
- Le signal en tension en sortie de l'au moins un amplificateur est réinjecté sur l'au moins une source de courant pilotée en tension.
- Avantageusement, le circuit de détermination est configuré pour assurer l'égalité entre les potentiels au niveau de chaque plot de sortie desdites première et deuxième séries de dipôles et le potentiel de référence (V_{REF}), correspondant généralement à la valeur (fixe ou variable) de consigne déterminée par l'utilisateur du circuit.
- Préférentiellement, le circuit de détermination est configuré pour appliquer (absorber ou injecter) un courant au niveau de chaque plot de sortie desdites première et deuxième séries de dipôles. Avantageusement, le circuit de détermination pilote l'absorption ou l'injection du courant.
- Avantageusement, le circuit de détermination est configuré pour déterminer le potentiel moyen (V_{MOY}),égal à la moyenne entre le potentiel au niveau du plot de sortie de la première série de dipôles et le potentiel au niveau du plot de la deuxième série de dipôles. Avantageusement, le circuit de détermination comprend un diviseur de tension relié au niveau de chaque plot de sortie desdites première et deuxième séries de dipôles pour fournir ce potentiel moyen (V_{MOY}).
- Le circuit de détermination comprend de préférence un amplificateur additionnel configuré de sorte à comparer, le potentiel moyen (V_{MOY}) et le potentiel de référence (V_{REF}).
- Avantageusement, le circuit de détermination pilote des transconductances reliées aux plots de sortie, chaque plot de sortie étant relié à une transconductance distincte. Les transconductances sont des sources de courant pilotées en tension.
- Préférentiellement, le dispositif comprend au moins un dipôle à impédance variable en fonction de l'évolution d'un mesurande dans au moins une parmi la première et/ou la deuxième séries de dipôles d'une branche de détection.
- Le circuit de polarisation comprend de préférence au moins une source de courant ou une source de tension.
- La source de courant comprend de préférence des transistors montés en miroir de courant.
- Avantageusement, le circuit de polarisation est configuré pour appliquer (par absorption ou injection) un courant de polarisation dans la branche de détection, notamment à une fréquence donnée. Selon un mode de réalisation, un signal plus complexe, notamment une fréquence pondérée par une fenêtre, sorte de filtrage réduit l'étalement spectral du signal. Ceci est notamment le cas pour une polarisation intermittente d'une branche, soit pour lire les autres branches, soit pour économiser de l'énergie.
- Le dispositif comprend une pluralité de branches de détection.
- Les premières séries de dipôles de chaque branche de détection sont connectées à un premier plot de sortie commun et les deuxièmes séries de dipôles de chaque branche de détection sont connectées à un deuxième plot de sortie commun.
- Le circuit de polarisation comprend une unique source de polarisation pour polariser la pluralité de branches et un commutateur configuré de sorte à appliquer un courant de manière successive dans chacune des branches de détection.
- Le commutateur commute d'une branche de détection à une autre pour une fréquence de commutation prédéterminée.
- Le circuit de polarisation comprend une source de polarisation pour chacune des branches de détection et est configuré pour délivrer un courant alternatif dans chacune des branches de détection.
- Le circuit de polarisation comprend un moyen de filtrage en fréquence. Selon un mode de réalisation dans lequel, le circuit de lecture permet de récupérer simultanément les valeurs de courant appliquées à chaque branche de détection, ledit circuit de lecture comporte en outre un moyen de filtrage en fréquence pour séparer les différentes valeurs mesurées.
- Le capteur multi-sensoriel comprend au moins un circuit de mesure.
- Le capteur comprend un microsystème et/ou nanosystème électromécanique.
- Le microsystème et/ou nanosystème électromécanique comporte au moins une masse mobile.

Dans la description, un axe de détection correspond à une chaine sensible à un mesurande. Un mesurande est une grandeur physique d'entrée transformée en une autre grandeur physique de sortie comme, par exemple, un signal électrique. Les grandeurs physiques peuvent être, par exemple, de type mécanique (notamment déplacement, force, masse, débit), thermique (notamment température, capacité thermique, flux thermique), électrique (courant, tension, charge, impédance, diélectrique), magnétique (notamment champ magnétique), radiatif (notamment lumière visible, rayons X, micro-ondes) ou encore (bio-) chimique (notamment humidité, gaz). Un capteur multi-sensoriel ou multi-axes correspond à un système possédant plusieurs axes de détection.

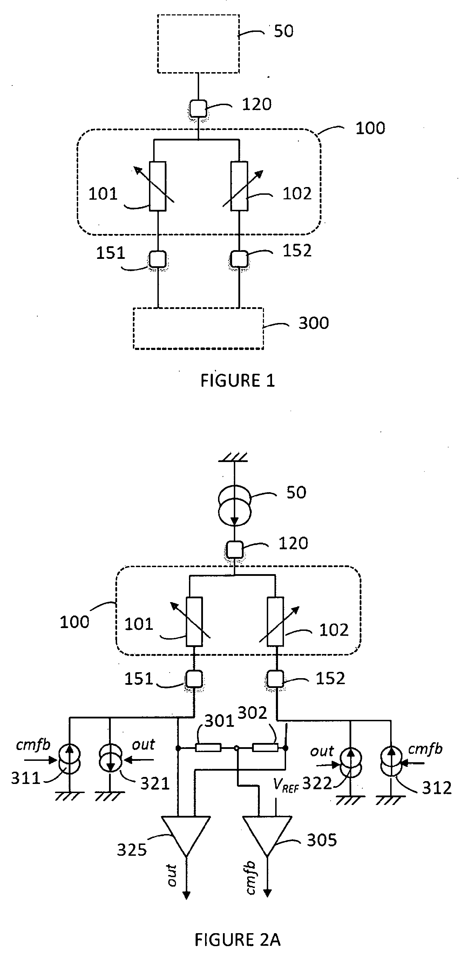

La **figure 1** illustre une représentation schématique du circuit de mesure selon l'invention. Le circuit de mesure comprend un circuit électrique. Le circuit électrique comprend au moins un circuit de polarisation 50 et un circuit de lecture 300 et une branche de détection 100 au moins sensible à un mesurande.
Le circuit de polarisation 50 est configuré de sorte à imposer un courant ou un potentiel sur un plot d'entrée 120 commun. Le plot d'entrée 120 commun est relié à une branche de détection 100. Une branche de détection 100 comprend une première série 101 de dipôles et une deuxième série 102 de dipôles. Ces séries 101, 102 de dipôles sont montées en parallèle et reliées en entrée au plot d'entrée 120 commun. La branche de détection 100 se présente préférentiellement sous la forme d'un demi-pont d'impédances différentielles à mesurer. La première série 101 de dipôles est reliée en sortie à un premier plot de sortie 151. La deuxième série 102 de dipôles est reliée à un deuxième plot de sortie 152. On entend par dipôle électrique, un composant électrique possédant deux bornes. On distingue en général deux sortes de dipôles. Les dipôles actifs produisent du courant électrique, tels les générateurs. Les dipôles passifs quant à eux reçoivent du courant électrique, tels les récepteurs, ce qui est avantageusement le cas des dépôts des séries 101 et 102. La polarisation en courant apporte un avantage considérable en cas de résistances parasites d'accès. Ce signal peut être constant ou alternatif.

Le circuit de lecture 300 est configuré de sorte à maintenir un même potentiel de référence (V_{REF}) au niveau du premier plot de sortie 151 et au niveau du deuxième plot de sortie 152. Avantageusement, le circuit de lecture comprend un circuit de détermination de variation d'impédances de chaque série 101, 102 de dipôles de la branche de détection 100 à partir du courant appliqué à chaque plot de sortie 151, 152 par le circuit de lecture pour maintenir l'égalité des potentiels. Le circuit de détermination comprend des moyens de détermination tels que des transconductances (sources de courant pilotées en tension), des amplificateurs, des amplificateurs différentiels, des dipôles.

La sortie du dispositif est un signal proportionnel à la différence des deux courants au niveau de chaque plot de sortie 151, 152. Cette différence correspond à une variation des impédances dans les première et deuxième séries 101, 102 de dipôles. Les impédances des dipôles des première et deuxième séries de dipôles 101, 102 sont de préférence polarisées. Préférentiellement, les séries 101, 102 de dipôles sont des résistances variables (c'est-à-dire dont la résistance électrique varie).

Grâce au potentiel commun maintenu à la sortie des impédances des première et deuxième séries 101, 102 de dipôles par le circuit de lecture 300, le courant de polarisation, appliqué à chacune des séries 101, 102 de dipôles, réagit comme si les impédances étaient en parallèle.

De manière particulièrement avantageuse, la différence de courant mesurée est directement proportionnelle à la variation des impédances.

Dans un pont de Wheastone classique, il est en général nécessaire d'ajouter des résistances de référence pour refermer le pont et une électronique de lecture la plus discrète possible pour ne pas perturber le fonctionnement de ce pont.

Dans la présente invention, le circuit de lecture 300 remplace les résistances de référence. L'électronique rétroagit directement sur les impédances des première et deuxième séries 101, 102 de dipôles.

La **figure 2A** illustre un mode de réalisation préféré, mais non limitatif de l'invention. Le circuit de polarisation 50 peut comprendre une source de courant réalisable, par exemple, au moyen de transistors, et notamment au travers d'un montage « en miroir de courant ».

Le circuit de lecture 300 est configuré de sorte à maintenir un potentiel commun entre le premier plot de sortie 151 et le deuxième plot de sortie 152. Le circuit de lecture 300 comprend un circuit de détermination apte à absorber ou appliquer un courant adéquat au niveau desdits plots de sortie 151, 152. Les moyens de détermination formant en partie le circuit de détermination sont configurés de sorte à fournir sur le plot de sortie noté « out », un signal correspondant à une tension proportionnel à la différence des courants injectés sur les plots 151,152.

Pour ce faire, le circuit de lecture 300 comprend avantageusement une première et une deuxième boucles ; lesdites boucles dites d'asservissement comprenant les moyens de détermination du circuit de détermination.

La première boucle est destinée à assurer un potentiel moyen en sortie, au niveau des plots de sortie 151, 152 des première et deuxième séries 101, 102 de dipôles. La première boucle comprend un pont diviseur de tension relié au niveau de chaque plot de sortie 151, 152. On entend par pont diviseur de tension, un montage électronique qui permet de diviser une tension d'entrée. Dans le cas de la présente invention, la tension d'entrée est la différence de potentiel entre le plot de sortie 151 de la première série 101 de dipôles et le plot de sortie 152 de la deuxième série 102 de dipôles. Ce type de montage est par exemple utilisé pour créer une tension de référence. Le pont diviseur de tension comprend de préférence deux résistances 301, 302 montées en série. Préférentiellement, les deux résistances 301, 302 ont la même valeur.

Le pont diviseur de tension permet de récupérer un potentiel moyen V_{MOY} au niveau des plots de sortie 151, 152 des première et deuxième séries 101, 102 de dipôles.

Avantageusement, la première boucle comprend également un amplificateur (ou comparateur) 305. On entend par amplificateur ou comparateur, un montage permettant de comparer une tension variable à une valeur constante. L'amplificateur 305 de la première boucle du circuit selon l'invention permet de comparer, en entrée, le potentiel moyen V_{MOY} au niveau des plots de sortie 151, 152 des première et deuxième séries 101, 102 de dipôles avec un potentiel de référence V_{REF}. Le potentiel de référence (V_{REF}) correspond de préférence à une valeur (fixe ou variable) de consigne, déterminée par l'utilisateur. Avantageusement, l'amplificateur 305 génère à sa sortie un signal en tension noté « cmfb ». Selon un mode de réalisation préféré mais non limitatif, le signal en tension « cmfb » de la sortie de l'amplificateur 305 coopère avec des transconductances 311, 312. Les transconductances 311, 312 sont de préférence chacune reliées à un différent parmi les plots de sortie 151, 152 des première et deuxième séries 101, 102 de dipôles. Les transconductances 301, 302 peuvent, de préférence, être des sources de courant pilotées en tension. Avantageusement, la première boucle est configurée de sorte à maintenir un potentiel moyen V_{MOY} en sortie des impédances des première et deuxième séries 101, 102 de dipôles; ledit potentiel étant préférentiellement égal à un potentiel prédéterminé. Les moyens de détermination de la première boucle sont de préférence configurés pour appliquer la moitié du courant de polarisation injecté dans chacune des première et deuxième séries 101, 102 de dipôles.

La deuxième boucle est destinée à assurer l'égalité des potentiels au niveau des plots de sortie 151, 152 des première et deuxième séries 101, 102 de dipôles. Les potentiels sont comparés au travers par exemple d'un amplificateur 325, dont ils réalisent la tension différentielle d'entrée. Avantageusement, l'amplificateur 325 génère à sa sortie un signal en tension noté « out ». Selon un mode de réalisation préféré mais non limitatif, le signal en tension « out » de la sortie de l'amplificateur 325 coopère avec des transconductances 321, 322. On peut employer des amplificateurs opérationnels pour réaliser les amplificateurs 305, 325 de l'invention. Les transconductances 321, 322 sont de préférence chacune reliées à un différent parmi les plots de sortie 151, 152 des première et deuxième séries 101, 102 de dipôles. Les transconductances 321, 322 peuvent être, par exemple, des sources de courant pilotées en tension. Selon un mode de réalisation, une première transconductance 321 est configurée pour appliquer une valeur de courant au niveau du plot de sortie 151 de la première série 101 de dipôles alors qu'une deuxième transconductance 322 est configurée pour appliquer ladite valeur de courant au niveau du plot de sortie 152 de la deuxième série 102 de dipôles.

Avantageusement, en régime établi, cette deuxième boucle est apte à maintenir des potentiels égaux aux niveaux des plots de sortie 151, 152 des première et deuxième séries 101, 102 de dipôles. En sortie du comparateur 325, le signal est, selon un mode de réalisation particulièrement avantageux, proportionnel à la différence entre le courant au niveau du plot de sortie 151 de la première série 101 de dipôles et le courant au niveau du plot de sortie 152 de la deuxième série 102 de dipôles. Ce signal représente la sortie du circuit.

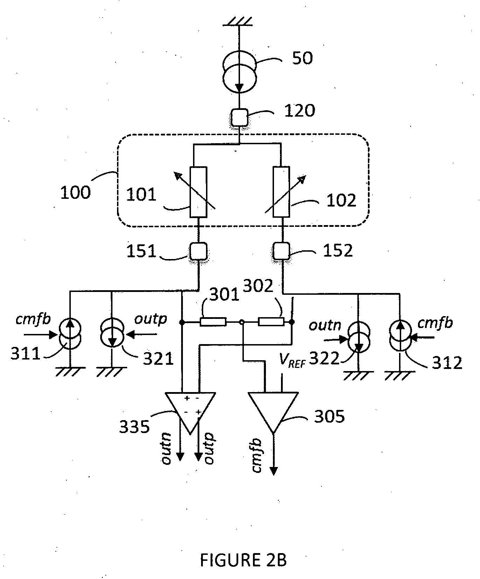

La figure 2B illustre une alternative au mode de réalisation illustré en figure 2A. Dans ce circuit de mesure, on utilise un amplificateur différentiel 335. Les potentiels sont comparés au travers par exemple d'un amplificateur 325, dont ils réalisent la tension différentielle d'entrée. Avantageusement, l'amplificateur 335 génère à sa sortie un premier signal en tension noté « outn » et un deuxième signal en tension noté « outp ». Selon un mode de réalisation préféré mais non limitatif, le premier signal en tension « outn » de la sortie de l'amplificateur 335 coopère avec au moins une première transconductance 321. Avantageusement, le deuxième signal en tension « outp » de la sortie de l'amplificateur 335 coopère avec au moins une deuxième transconductance 322.

De manière particulièrement avantageuse, travailler en mode différentiel apporte des avantages considérables en termes de résistance aux bruits (en mode commun), de linéarité et de réduction du décalage (en anglais « offset ») éventuellement observé dans le signal de sortie.

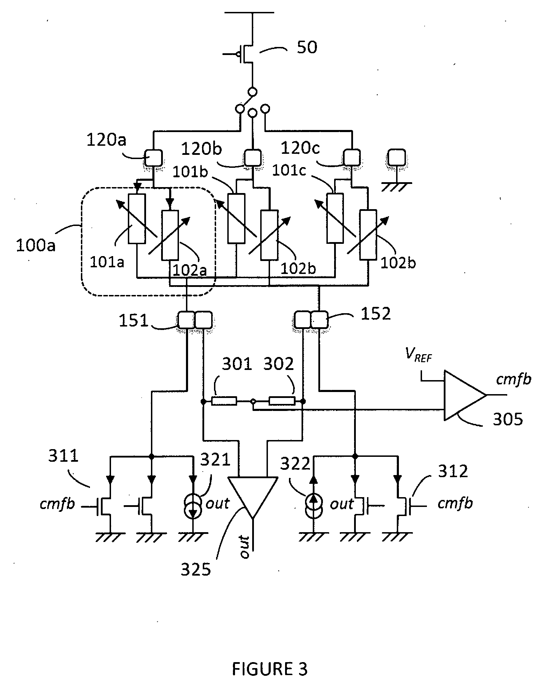

La **figure 3** illustre une représentation schématique du circuit de mesure selon l'invention comprenant une pluralité de branches de détection telles que celle repérée 100a en figure 3, chacune des branches de détection au nombre de trois dans la figure 3 comprenant un plot de polarisation 120a, 120b, 120c distinct. Selon un mode de réalisation préféré, un interrupteur est relié à une source de polarisation de sorte à commuter sur chacun des plots de polarisation 120a, 120b, 120c de différentes branches de détection.
Selon ce mode de réalisation où le circuit comprend une pluralité de branches de détection, lesdites branches de détection comprennent chacune une première série 101a, 101b, 101c et une deuxième série 102a, 102b, 102c de dipôles. Dans ce mode de réalisation, les premières séries de dipôles de chaque branche de détection sont toutes connectées à un premier plot de sortie 151 et les deuxièmes séries de dipôles de chaque branche de détection sont connectées à un deuxième plot de sortie 152.
Avantageusement, le partage des plots de sortie 151, 152 optimise l'encombrement et permet notamment de réduire le nombre de plots.

Dans un circuit configuré selon un pont de Wheastone, la mutualisation des plots de sortie est impossible car les signaux se mélangeraient au lieu de se superposer. Seule la mutualisation du plot de polarisation est possible, ce qui limite le gain (toujours deux plots de sortie par axe de détection).

Dans la présente invention, un seul plot de polarisation 120a, 120b, 120c par axe de détection est nécessaire. L'optimisation du nombre de plots est d'autant plus avantageuse que le nombre d'axes de détection augmente.
Afin d'isoler le signal de chaque axe de détection, il est nécessaire de les séparer, par exemple, de manière temporelle ou encore de manière fréquentielle. Pour une séparation temporelle des signaux, il est préférable de polariser les branches de détection les unes après les autres, sans toutefois superposer les signaux. Pour une séparation fréquentielle, il est envisageable de polariser simultanément les branches de détection avec des courants, de préférence, alternatifs. Ces courants ont chacun une fréquence spécifique pour pouvoir les dissocier par mixage et filtrage. L'invention permet de mesurer tous les axes de détection au moyen d'une seule électronique, privilégiant les performances à la consommation de polarisation.

Dans la présente invention, les plots de sortie 151, 152 sont mutualisés et les plots de polarisation 120 sont distincts. On peut ainsi choisir de n'alimenter que les axes de détection désirés, évitant de ce fait, la perte de courant dans les axes de détection non lus, et de ce fait, limiter la chute de potentiel au niveau des plots de sortie 151, 152, en cas de résistance d'accès au niveau des plots.

Un des avantages de l'invention est, dans un mode de réalisation, d'opérer l'ajout de deux plots uniquement, indépendamment du nombre d'axes de détection. Plus précisément, pour s'affranchir de l'effet de résistances parasites, on opère une mesure « quatre pointes » pour dédoubler les plots de sortie 151, 152 du circuit de lecture 300 afin de dissocier les fonctions de lecture et les fonctions de rétroaction. Les plots 151, 152 sont alors formés chacun d'une paire de plots élémentaires. Le premier plot de chaque paire de plots 151, 152 de sortie sert à la lecture du potentiel. L'électronique associée, présentant une impédance très forte, va consommer un courant très faible, limitant ainsi les chutes de tension non maitrisées dans les résistances parasites d'accès. La mesure n'est donc que très peu perturbée. D'autre part, l'électronique de rétroaction qui absorbe les courants non négligeables va subir des chutes de tension non maitrisées dans les résistances parasites d'accès, mais sans conséquence car aucune lecture ne se fait sur la paire de plots associée. La rétroaction des première et deuxième boucles d'asservissement se faisant en courant, elle ne sera pas sensible à ce défaut.
D'autre part, l'alimentation en courant nous permet de maitriser la polarisation tout en ne gardant qu'un plot de polarisation 120 par axe de détection. Une chute de potentiel pourra être observée au niveau des résistances d'accès. Toutefois, la source de polarisation est avantageusement configurée de sorte à imposer un courant quelle que soit l'impédance des dipôles. Il n'est avantageusement plus nécessaire de mesurer la tension de polarisation effective, comme cela est fait lors d'une mesure « quatre pointes » classique.

Dans la présente invention, l'électronique de lecture et les impédances des séries de dipôles 101, 102 interagissent afin d'assurer un même potentiel de référence (V_{REF}) au niveau des plots de sortie 151, 152 desdites séries de dipôles 101, 102. La présente invention permet également d'éviter le recours à des résistances de référence pour compléter le pont. L'invention permet avantageusement de minimiser le nombre de plots de sortie 151, 152 dans le cas d'une lecture de plusieurs axes de détection. Elle ne requiert en outre qu'un plot d'entrée supplémentaire par axe. Lors d'une mesure « quatre pointes », seulement deux plots supplémentaires sont nécessaires, indépendamment du nombre d'axes de détection. Il n'est pas utile de mesurer une tension de polarisation effective. Les impédances des première et deuxième séries 101, 102 de dipôles peuvent être alimentées indépendamment les unes par rapport aux autres pour limiter la consommation de polarisation. Les impédances peuvent être lues en même temps par la même électronique pour augmenter les performances.

La présente invention n'est pas limitée aux modes de réalisation précédemment décrits mais s'étend à tout mode de réalisation couvert par les revendications. En outre, le circuit de mesure n'exclut pas la présence d'autres parties, dont des ponts de Wheatstone indépendants en plus.

## Revendications

1. Circuit de mesure de variation d'impédances pour un capteur comprenant au moins une branche de détection (100) comprenant au moins une première série (101) d'au moins un dipôle et une deuxième série (102) d'au moins un dipôle, les séries étant montées en parallèle et reliées en entrée à un plot d'entrée commun (120) ; chaque série (101, 102) de dipôles étant reliée à un plot de sortie (151, 152) distinct, comprenant un circuit électronique comprenant un circuit de polarisation (50) configuré pour appliquer un courant de polarisation dans ladite branche de détection (100) à partir du plot d'entrée (120), et un circuit de lecture (300), comprenant au moins une source de courant pilotée en tension, configuré pour imposer à chaque plot de sortie (151, 152) un même potentiel dit potentiel de référence (V_{REF}) ; ledit circuit électronique comportant en outre un circuit de détermination de variations d'impédances de chaque série (101, 102) de dipôles de la branche de détection (100) à partir du courant appliqué à chaque plot de sortie (151, 152) par le circuit de lecture pour maintenir l'égalité des potentiels ; le circuit de détermination comprenant des transconductances, chaque plot de sortie (151,152) étant relié à une transconductance distincte, les transconductances étant configurées pour appliquer un courant au niveau de chaque plot de sortie (151, 152) desdites première et deuxième séries de dipôles (101, 102), le circuit de détermination étant configuré pour fournir en sortie un signal en tension proportionnel à la différence entre le courant au niveau du plot de sortie (151) de la première série (101) de dipôles et le courant au niveau du plot de sortie (152) de la deuxième série (102) de dipôles.

2. Circuit selon la revendication précédente dans lequel le circuit de détermination est configuré pour assurer l'égalité entre un premier potentiel relevé au niveau de l'un parmi les plots de sortie (151, 152) et un deuxième potentiel relevé au niveau de l'autre parmi les plots de sortie (151, 152).

3. Circuit selon la revendication précédente dans lequel le circuit de détermination comprend au moins un amplificateur (325) configuré de sorte à comparer, à son entrée, les premier et deuxième potentiels au niveau de chacun des plots de sortie (151, 152) desdites première et deuxième séries (101, 102) de dipôles.

4. Circuit selon la revendication précédente dans lequel l'au moins un amplificateur (325, 335) est configuré de sorte à générer à sa sortie un signal en tension (out, outn, outp).

5. Circuit selon la revendication précédente dans lequel le signal en tension en sortie de l'au moins un amplificateur (325, 335) est réinjecté sur l'au moins une source de courant pilotée en tension.

6. Circuit selon l'une quelconque des deux revendications précédentes, dans lequel l'amplificateur (335) est différentiel et est configuré pour générer à sa sortie un premier signal en tension (outn) et un deuxième signal en tension (outp).

7. Circuit selon l'une quelconque des revendications précédentes dans lequel le circuit de détermination est configuré pour déterminer un potentiel moyen (V_{MOY}), égal à la moyenne entre le potentiel au niveau du plot de sortie (151) de la première série (101) de dipôles et le potentiel au niveau du plot de sortie (152) de la deuxième série (102) de dipôles.

8. Circuit selon la revendication précédente dans lequel le circuit de détermination comprend un pont diviseur de tension relié au niveau de chaque plot de sortie (151, 152) desdites première et deuxième séries de dipôles (101, 102) et fournissant le potentiel moyen (V_{MOY}).

9. Circuit selon l'une des deux revendications précédentes dans lequel le circuit de détermination comprend un amplificateur additionnel (305) configuré de sorte à comparer, à son entrée, le potentiel moyen (V_{MOY}) et le potentiel de référence (V_{REF}).

10. Circuit selon l'une quelconque des revendications précédentes dans lequel chaque plot de sortie (151, 152) est formé d'une paire de plots élémentaires, un premier plot élémentaire de chaque paire étant relié au circuit de lecture, un second plot élémentaire de chaque paire étant relié à une, distincte, des transconductances.

11. Circuit selon l'une quelconque des revendications précédentes comprenant au moins un dipôle à impédance variable en fonction de l'évolution d'un mesurande dans au moins une parmi la première et/ou la deuxième séries de dipôles d'une branche de détection (100).

12. Circuit selon l'une quelconque des revendications précédentes dans lequel le circuit de polarisation (50) est configuré pour appliquer un courant de polarisation dans la branche de détection (100), à une fréquence donnée.

13. Circuit selon l'une quelconque des revendications précédentes comprenant une pluralité de branches de détection (100a) et dans lequel, avantageusement, les premières séries de dipôles de chaque branche de détection (100a) sont connectées à un premier plot de sortie (151) commun et les deuxièmes séries de dipôles de chaque branche de détection sont connectées à un deuxième plot de sortie (152) commun.

14. Circuit selon la revendication précédente dans lequel le circuit de polarisation (50) comprend une unique source de polarisation pour polariser la pluralité de branches (100a) et un commutateur configuré de sorte à appliquer du courant de manière successive dans chacune des branches de détection (100a).

15. Circuit selon la revendication précédente dans lequel le commutateur commute d'une branche de détection (100a) à une autre pour une fréquence de commutation prédéterminée.

16. Circuit selon l'une quelconque des revendications 13 et 14 dans lequel le circuit de polarisation (50) comprend une source de polarisation pour chacune des branches de détection (100a) et est configuré pour délivrer un courant alternatif dans chacune des branches de détection (100a).

17. Circuit selon l'une quelconque des revendications précédentes dans lequel le circuit de lecture (300) comprend un moyen de filtrage en fréquence.

18. Capteur comprenant au moins un circuit de mesure selon l'une quelconque des revendications précédentes.

19. Procédé de mesure comprenant l'utilisation d'un circuit de mesure comprenant au moins une branche de détection (100) comprenant une première série (101) d'au moins un dipôle et une deuxième série (102) d'au moins un dipôle, les séries étant montées en parallèle et reliées en entrée à un plot d'entrée commun (120) ; chaque série (101, 102) de dipôles étant reliée à un plot de sortie (151, 152) distinct, et comprenant les étapes suivantes :
- application d'un courant de polarisation dans ladite branche de détection (100) à partir du plot d'entrée (120),
- imposition à chaque plot de sortie (151, 152) d'un même potentiel, dit de référence (V_{REF}),
- détermination de variations d'impédances de chaque série (101, 102) de dipôles de la branche de détection (100), au moyen d'un circuit de détermination, à partir du courant appliqué, avec une source de courant pilotée en tension, à chaque plot de sortie (151, 152) pour maintenir l'égalité des potentiels; le circuit de détermination appliquant un courant au niveau de chaque plot de sortie (151, 152) desdites première et deuxième séries de dipôles (101, 102) par des transconductances, chaque plot de sortie (151,152) étant relié à une transconductance distincte,
- le circuit de détermination étant configuré pour fournir en sortie un signal en tension proportionnel à la différence entre le courant au niveau du plot de sortie (151) de la première série (101) de dipôles et le courant au niveau du plot de sortie (152) de la deuxième série (102) de dipôles.

## Patentansprüche

1. Schaltung zur Messung von Impedanzvariationen für einen Sensor, umfassend mindestens einen Detektionszweig (100), umfassend mindestens eine erste Serie (101) mindestens eines Dipols und eine zweite Serie (102) mindestens eines Dipols, wobei die Serien parallel montiert und am Eingang mit einem gemeinsamen Eingangsanschluss (120) verbunden sind; wobei jede Serie (101, 102) von Dipolen mit einen bestimmten Ausgangsanschluss (151, 152) verbunden ist,
umfassend eine elektronische Schaltung, umfassend eine Polarisationsschaltung (50), die ausgelegt ist, einen Polarisationsstrom von dem Eingangsanschluss (120) in dem Detektionszweig (100) anzulegen, und eine Leseschaltung (300), umfassend mindestens eine spannungsgesteuerte Stromquelle, die ausgelegt ist, an jeden Ausgangsanschluss (151, 152) das gleiche Potential anzulegen, das als Referenzpotential (V_{REF}) bezeichnet wird; wobei die elektronische Schaltung außerdem eine Schaltung zur Bestimmung von Impedanzvariationen jeder Serie (101, 102) von Dipolen des Detektionszweigs (100) von dem an jeden Ausgangsanschluss (151, 152) durch die Leseschaltung angelegten Strom umfasst, um die Potentiale gleich zu halten; wobei die Bestimmungsschaltung Transkonduktanzen umfasst, wobei jeder Ausgangsanschluss (151, 152) mit einer bestimmten Transkonduktanz verbunden ist, wobei die Transkonduktanzen ausgelegt sind, einen Strom auf der Höhe jedes Ausgangsanschlusses (151, 152) der ersten und zweiten Serie (101, 102) von Dipolen anzulegen, wobei die Bestimmungsschaltung ausgelegt ist, am Ausgang ein Spannungssignal proportional zu der Differenz zwischen dem Strom auf der Höhe des Ausgangsanschlusses (151) der ersten Serie (101) von Dipolen und dem Strom auf der Höhe des Ausgangsanschlusses (152) der zweiten Serie (102) von Dipolen zu liefern.

2. Schaltung nach dem vorhergehenden Anspruch, wobei die Bestimmungsschaltung ausgelegt ist, die Gleichheit zwischen einem ersten erhöhten Potential auf der Höhe eines von den Ausgangsanschlüssen (151, 152) und einem zweiten erhöhten Potential auf der Höhe des anderen von den Ausgangsanschlüssen (151, 152) sicherzustellen.

3. Schaltung nach dem vorhergehenden Anspruch, wobei die Bestimmungsschaltung mindestens einen Verstärker (325) umfasst, der ausgelegt ist, an seinem Eingang das erste und zweite Potential auf der Höhe jedes der Ausgangsanschlüsse (151, 152) der ersten und zweiten Serie (101, 102) von Dipolen zu vergleichen.

4. Schaltung nach dem vorhergehenden Anspruch, wobei mindestens ein Verstärker (325, 335) ausgelegt ist, an seinem Ausgang ein Spannungssignal (out, outn, outp) zu generieren.

5. Schaltung nach dem vorhergehenden Anspruch, wobei das Spannungssignal am Ausgang des mindestens einen Verstärkers (325, 335) in mindestens eine spannungsgesteuerte Stromquelle erneut eingegeben wird.

6. Schaltung nach einem der zwei vorhergehenden Ansprüche, wobei der Verstärker (335) ein Differentialverstärker und ausgelegt ist, an seinem Ausgang ein erstes Spannungssignal (outn) und ein zweites Spannungssignal (outp) zu generieren.

7. Schaltung nach einem der vorhergehenden Ansprüche, wobei die Bestimmungsschaltung ausgelegt ist, ein Mittelpotential (V_{MOY}) gleich dem Mittel zwischen dem Potential auf der Höhe des Ausgangsanschlusses (151) der ersten Serie (101) von Dipolen und dem Potential auf der Höhe des Ausgangsanschlusses (152) der zweiten Serie (102) von Dipolen zu bestimmen.

8. Schaltung nach dem vorhergehenden Anspruch, wobei die Bestimmungsschaltung eine Spannungsteilerbrücke umfasst, die auf der Höhe jedes Ausgangsanschlusses (151, 152) der ersten und zweiten Serie von Dipolen (101, 102) angeschlossen ist und das Mittelpotential (V_{MOY}) liefert.

9. Schaltung nach einem der zwei vorhergehenden Ansprüche, wobei die Bestimmungsschaltung einen zusätzlichen Verstärker (305) umfasst, der ausgelegt ist, an seinem Eingang das Mittelpotential (V_{MOY}) und das Referenzpotential (V_{REF}) zu vergleichen.

10. Schaltung nach einem der vorhergehenden Ansprüche, wobei jeder Ausgangsanschluss (151, 152) aus einem Paar von Anschlusselementen gebildet ist, wobei ein erstes Anschlusselement jedes Paars mit der Leseschaltung verbunden ist, und ein zweites Anschlusselement jedes Paars mit einer bestimmten der Transkonduktanzen verbunden ist.

11. Schaltung nach einem der vorhergehenden Ansprüche, umfassend mindestens einen Dipol mit variabler Impedanz entsprechend der Entwicklung einer Messgröße in mindestens einer von der ersten und/oder der zweiten Serie von Dipolen eines Detektionszweigs (100).

12. Schaltung nach einem der vorhergehenden Ansprüche, wobei die Polarisationsschaltung (50) ausgelegt ist, einen Polarisationsstrom in dem Detektionszweig (100) bei einer gegebenen Frequenz anzulegen.

13. Schaltung nach einem der vorhergehenden Ansprüche, umfassend mehrere Detektionszweige (100a), und wobei vorteilhaft die ersten Serien von Dipolen jedes Detektionszweigs (100a) mit einem ersten gemeinsamen Ausgangsanschluss (151) verbunden sind, und die zweiten Serien von Dipolen jedes Detektionszweigs mit einem zweiten gemeinsamen Ausgangsanschluss (152) verbunden sind.

14. Schaltung nach dem vorhergehenden Anspruch, wobei die Polarisationsschaltung (50) eine einzige Polarisationsquelle zur Polarisation der mehreren Zweige (100a) und einen Schalter umfasst, der ausgelegt ist, Strom sukzessiv in jedem der Detektionszweige (100a) anzulegen.

15. Schaltung nach dem vorhergehenden Anspruch, wobei der Schalter von einem Detektionszweig (100a) zu einem anderen bei einer vorherbestimmten Schaltfrequenz umschaltet.

16. Schaltung nach einem der Ansprüche 13 und 14, wobei die Polarisationsschaltung (50) eine Polarisationsquelle für jeden der Detektionszweige (100a) umfasst und ausgelegt ist, einen Wechselstrom in jedem der Detektionszweige (100a) zu liefern.

17. Schaltung nach einem der vorhergehenden Ansprüche, wobei die Leseschaltung (300) ein Frequenzfiltermittel umfasst.

18. Sensor, umfassend mindestens eine Messschaltung nach einem der vorhergehenden Ansprüche.

19. Verfahren zur Messung, umfassend die Verwendung einer Messschaltung, umfassend mindestens einen Detektionszweig (100), umfassend eine erste Serie (101) mindestens eines Dipols und eine zweite Serie (102) mindestens eines Dipols, wobei die Serien parallel montiert und am Eingang mit einem gemeinsamen Eingangsanschluss (120) verbunden sind; wobei jede Serie (101, 102) von Dipolen mit einen bestimmten Ausgangsanschluss (151, 152) verbunden ist, und umfassend die folgenden Schritte:
- Anlegen eines Polarisationsstroms von dem Eingangsanschluss (120) in dem Detektionszweig (100),
- Anlegen des gleichen Potentials, das als Referenzpotential (V_{REF}) bezeichnet wird, an jeden Ausgangsanschluss (151, 152),
- Bestimmen von Impedanzvariationen jeder Serie (101, 102) von Dipolen des Detektionszweigs (100), durch eine Bestimmungsschaltung, von dem mit einer spannungsgesteuerten Stromquelle an jeden Ausgangsanschluss (151, 152) angelegten Strom, um die Potentiale gleich zu halten, wobei die Bestimmungsschaltung einen Strom auf der Höhe jedes Ausgangsanschlusses (151, 152) der ersten und zweiten Serie (101, 102) von Dipolen durch Transkonduktanzen anlegt, wobei jeder Ausgangsanschluss (151, 152) mit einer bestimmten Transkonduktanz verbunden ist,
- wobei die Bestimmungsschaltung ausgelegt ist, am Ausgang ein Spannungssignal proportional zu der Differenz zwischen dem Strom auf der Höhe des Ausgangsanschlusses (151) der ersten Serie (101) von Dipolen und dem Strom auf der Höhe des Ausgangsanschlusses (152) der zweiten Serie (102) von Dipolen zu liefern.

## Claims

1. A measurement circuit for a sensor, the measurement circuit including at least one detection branch (100) including at least a first series (101) of at least one dipole and a second series (102) of at least one dipole, the series being connected in parallel and connected at their inputs to a common input terminal (120); each series (101, 102) of dipole being connected to a distinct output terminal (151, 152);
comprising an electronic circuit including a bias circuit (50) configured to apply a bias current to said detection branch (100) from the input terminal (120), and a read circuit (300), including at least one voltage-controlled current source, configured to impose on each output terminal (151, 152) the same potential referred to as the reference potential (V_{REF}); said electronic circuit including therewith a determination circuit for determining variations in impedances of each series (101, 102) of dipole of the detection branch (100) on the basis of the current applied to each output terminal (151, 152) by the read circuit so as to keep the potentials equal; the determination circuit comprising transconductors, each output terminal being connected to a distinct transconductor, said transconductors being configured to apply a current to each output terminal (151, 152) of each series (101, 102) of dipole, the determination circuit being configured to deliver as output a voltage signal that is proportional to the difference between the current at the output terminal (151) of the first series (101) of dipole and the current at the output terminal (152) of the second series (102) of dipole.

2. A circuit according to the preceding claim, wherein the determination circuit is configured to guarantee equality between a first potential read at one of the output terminals (151, 152) and a second potential read at the other of the output terminals (151, 152).

3. A circuit according to the preceding claim, wherein the determination circuit includes at least one amplifier (325) configured in such a manner as to compare, at its input, the first and second potentials at each of the output terminals (151, 152) of said first and second series (101, 102) of dipole.

4. A circuit according to the preceding claim, wherein the at least one amplifier (325, 335) is configured in such a manner as to generate at its output a voltage signal (out, outn, outp).

5. A circuit according to the preceding claim, wherein the voltage signal at the output of the at least one amplifier (325, 335) is reinjected into the at least one voltage-controlled current source.

6. A circuit according to any of the two preceding claims, wherein the amplifier (335) is a differential amplifier and is configured to generate, at its output, a first voltage signal (outn) and a second output voltage signal (outp).

7. A circuit according to any preceding claims, wherein the determination circuit is configured to determine an average potential (V_{average}) equal to the average between the potential at the output terminal (151) of the first series (101) of dipole and the potential at the output terminal (152) of the second series (102) of dipole.

8. A circuit according to the preceding claim, wherein the determination circuit includes a voltage divider bridge connected to each output terminal (151, 152) of said first and second series of dipole (101, 102), and delivering the average potential (V_{average}).

9. A circuit according to either of the two preceding claims, wherein the determination circuit includes an additional amplifier (305) configured in such a manner as to compare, at its input, the average potential (V_{average}) and the reference potential (V_{REF}).

10. A circuit according to any preceding claims, wherein each of the output terminals (151, 152) is formed by a pair of elementary terminals, a first elementary terminal of each pair being connected to the read circuit, a second elementary terminal of each pair being connected to a disctinct transconductor among the transconductors.

11. A circuit according to any preceding claims, including at least one dipole having impedance that is variable as a function of the variation in a measurand in at least one among the first and/or second series of dipole of a detection branch (100).

12. A circuit according to any preceding claims, wherein the bias circuit (50) is configured to apply a bias current to the detection branch (100), at a given frequency.

13. A circuit according to any preceding claims including a plurality of detection branches (100a) and wherein, advantageously, the first series of dipole of each of the detection branches (100a) are all connected to a common first output terminal (151), and the second series of dipole of each of the detection branches are connected to a common second output terminal (152).

14. A circuit according to the preceding claim, wherein the bias circuit (50) includes a single bias source for biasing the plurality of detection branches (100a) and a switch configured in such a manner as to apply the current to each of the detection branches (100a) successively.

15. A circuit according to the preceding claim, wherein the switch switches over from one detection branch (100a) to another at a predetermined switch-over frequency.

16. A circuit according to either one of claims 13 and 14, wherein the bias circuit (50) includes a bias source for each of the detection branches (100a), and is configured to deliver alternating current to each of the detection branches (100a) successively.

17. A circuit according to any preceding claims, wherein the read circuit (300) includes frequency filtering means.

18. A sensor including at least one measurement circuit according to any preceding claims.

19. A measurement method comprising use of a measurement circuit including at least one detection branch (100) including at least a first series (101) of at least one dipole and a second series (102) of at least one dipole, the series being connected in parallel and connected at their inputs to a common input terminal (120); each series (101, 102) of dipole being connected to a distinct output terminal (151, 152), and the method further comprising the following steps:
- applying a bias current to said detection branch (100) from the input terminal (120);
- imposing on each output terminal (151, 152) the same potential, referred to as the reference potential (V_{REF});
- determining variations in impedances of each series (101, 102) of dipole of the detection branch (100), by means of a determination circuit, on the basis of the current applied, with a voltage-controlled current source, to each output terminal (151, 152) so as to keep the potentials equal; the determination circuit applying a current to each output terminal (151, 152) of said first and second series (101, 102) of dipole through transconductors, each output terminal being connected to a distinct transconductor;
- the determination circuit being configured to deliver as output a voltage signal that is proportional to the difference between the current at the output terminal (151) of the first series (101) of dipole and the current at the output terminal (152) of the second series (102) of dipole.
